**Europäisches Patentamt**

**European Patent Office**

**Office européen des brevets**

(11) Veröffentlichungsnummer: **0 410 337 A2**

# (12) EUROPÄISCHE PATENTANMELDUNG

(21) Anmeldenummer: 90114028.5

(22) Anmeldetag: 21.07.90

(51) Int. Cl.5: **C23C 14/06**, C23C 14/08, G11B 11/10

(30) Priorität: 28.07.89 DE 3925050

(43) Veröffentlichungstag der Anmeldung:
30.01.91 Patentblatt 91/05

(84) Benannte Vertragsstaaten:
**DE FR GB NL**

(71) Anmelder: **BASF Aktiengesellschaft**
**Carl-Bosch-Strasse 38**
**D-6700 Ludwigshafen(DE)**

(72) Erfinder: **Steininger, Helmut, Dr.**
**Dr.-Ernst-Kilb-Weg 15**
**D-6520 Worms 26(DE)**

(54) Schutzschichten aus Keramiken des Germaniums.

(57) Die neuartigen polykristallinen, unorientierten oder röntgenamorphen Carbid-, Oxid- und/oder Nitridkeramiken, welche von der Elementzusammensetzung I gebildet werden,

$$Ge_{1-x}M_x \quad (I)$$

worin die Indizes und die Variablen die folgende Bedeutung haben:
M mindestens ein Element aus der Gruppe Titan, Zirkon, Hafnium, Thorium, Scandium, Yttrium, Lanthan, Cer, Praseodym, Neodym, Samarium, Europium, Gadolinium, Terbium, Dysprosium, Holmium, Erbium, Thulium, Ytterbium, Lutetium, Vanadin, Niob, Tantal, Chrom, Molybdän, Wolfram, Mangan, Rhenium, Eisen, Kobalt, Nickel, Ruthenium, Rhodium, Kupfer, Zink, Magnesium, Kalzium, Strontium, Barium, Bor, Aluminium, Gallium, Indium, Thallium, Zinn, Blei, Phosphor, Arsen, Antimon, Wismut und Tellur;
x 0,01 bis 0,7,
lassen sich in der Form dünner Schichten als Diffusionssperren, Antikorrosionsschichten oder Interferenzschichten, zum Schutz von Oberflächen vor mechanischem Abrieb oder zum Schutz magneto-optischer Aufzeich-nungsschichten vor Korrosion verwenden. Diese neuen dünnen polykristallinen, unorientierten oder röntgena-morphen Schichten aus Keramiken des Germaniums lassen sich mit Hilfe der reaktiven Kathodenzerstäubung oder reaktiven Magnetronkathodenzerstäubung einer Kathode herstellen, welche aus der vorstehend aufgeführ-ten Elementzusammensetzung I besteht.

EP 0 410 337 A2

## SCHUTZSCHICHTEN AUS KERAMIKEN DES GERMANIUMS

Die vorliegende Erfindung betrifft polykristalline, unorientierte oder röntgenamorphe Carbid-, Oxid- und/oder Nitridkeramiken, welche von der Elementzusammensetzung 1 gebildet werden,

$$Ge_{1-x}M_x \qquad (1)$$

worin die Indizes und die Variablen die folgende Bedeutung haben:

M mindestens ein Element aus der Gruppe Titan, Zirkon, Hafnium, Thorium, Scandium, Yttrium, Lanthan, Cer, Praseodym, Neodym, Samarium, Europium, Gadolinium, Terbium, Dysprosium, Holmium, Erbium, Thulium, Ytterbium, Lutetium, Vanadin, Niob, Tantal, Chrom, Molybdän, Wolfram, Mangan, Rhenium, Eisen, Kobalt, Nickel, Ruthenium, Rhodium, Kupfer, Zink, Magnesium, Kalzium, Strontium, Barium, Bor, Aluminium, Gallium, Indium, Thallium, Zinn, Blei, Phosphor, Arsen, Antimon, Wismut und Tellur;

x 0,01 bis 0,7.

Außerdem betrifft die vorliegende Erfindung dünne Schichten, welche aus diesen Keramiken des Germaniums bestehen, sowie deren Verwendung als Diffusionssperren, Antikorrosionsschichten oder Interferenzschichten, zum Schutz von Oberflächen vor mechanischem Abrieb oder zum Schutz magnetooptischer Aufzeichnungsschichten vor Korrosion.

Darüber hinaus betrifft die vorliegende Erfindung ein neues magneto-optisches Aufzeichnungselement, welches mindestens eine dünne Schicht aus einer der eingangs definierten neuen Keramiken des Germaniums enthält.

Ferner betrifft die vorliegende Erfindung ein Verfahren zur Herstellung dünner Schichten, welche aus den eingangs definierten Keramiken des Germaniums bestehen.

Dünne polykristalline oder röntgenamorphe Schichten aus Carbid-, Oxid-und/oder Nitridkeramiken, welche von der Elementzusammensetzung

$$(Al_xSi_{1-x})_{1-z}(M_r^1M_s^2M_t^3)_z$$

gebildet werden, werden in EP-A- 0 326 932 beschrieben.

Aufgrund dieser allgemeinen Formel können unter Beachtung der anmeldungsgemäßen Bedingungen:

$M^1$, $M^2$ und $M^3$ Ti, Zr, Hf, Th, Sc, Y, La, Ce, Pr, Nd, Sm, Eu, Gd, Tb, Dy, Ho, Er, Tm, Yb, Lu, V, Nb, Ta, Cr, Mo, W, Mn, Re, Fe, Co, Rh, Cu, Zn, Mg, Ca,, Sr, Ba, B, Ga, In, Tl, Ge, Sn, Pb, P, As, Sb und Te, mit den Maßgaben, daß $M^1$, $M^2$ und $M^3$ voneinander verschieden sind, oder daß sie gleich oder verschieden voneinander sind, wenn es sich bei $M^1$, $M^2$ und $M^3$ um Lanthan oder ein Lanthanid handelt;

x 0 bis 1;

z r + s + t;

r 0,005 bis 0,15;

s 0,005 bis 0,15;

t 0 bis 0,005,

Germanium-haltige Keramiken hergeleitet werden, wie z.B. die Nitridkeramik

$Al_{0,695}Ge_{0,15}La_{0,155}N$,

welche allerdings nur maximal 15 Atom-% Germanium enthalten können. Die in EP-A-0 326 932 beschriebenen polykristallinen oder röntgenamorphen Keramikschichten dienen vor allem dem Schutz magnetooptischer Aufzeichnungsschichten aus amorphen Lanthanid-Übergangsmetall-Legierungen vor der Korrosion.

Aus der US-A-4 661 420 ist eine dünne, röntgenarmophe Schicht bekannt, welche neben Germanium oder Germanium und Silicium noch mindestens ein weiteres Element aus der Gruppe Wasserstoff, Kohlenstoff, Fluor, Stickstoff und Sauerstoff in Mengen bis zu 50 Atom-% insbesondere 30 Atom-%, enthält. Diese bekannte dünne röntgenamorphe Schicht dient der Erhöhung des Kerr-Drehwinkels der Aufzeichnungsschicht von magneto-optischen Aufzeichnungselementen.

Über die Korrosionsschutzwirkung der Germanium enthaltenden, dünnen röntgenamorphen Schicht werden in der US-A-4 661 420 keinerlei Angaben gemacht. Ebensowenig gehen aus EP-A-0 326 932 Angaben über den Einfluß der darin beschriebenen polykristallinen oder röntgenamorphen Keramikschicht auf den Kerr-Drehwinkel hervor.

Magneto-optische Aufzeichnungselemente sind gleichfalls bekannt. Im allgemeinen enthalten sie einen optisch transparenten dimensionsstabilen Träger (A), eine thermisch veränderbare Aufzeichnungsschicht (B) aus einer amorphen Lanthanid-Übergangsmetall-Legierung und - zumindest auf der dem Träger (A) abgewandten Seite der Aufzeichnungsschicht (B) - eine polykristalline oder röntgenamorphe Antikorrosionsschicht (C). Darüber hinaus können diese bekannten magneto-optischen Aufzeichnungselemente weitere Schichten wie Reflektionsschicht, oder Interferenzschichten aufweisen.

Diese bekannten mangneto-optischen Aufzeichnungselemente dienen dem Schreiben von Daten mit Hilfe impulsmodulierter Laserstrahlen, welche auf die Aufzeichnungsschichten (B) fokussiert sind und/oder senkrecht auf diese auftreffen.

Beim Schreiben von Daten wird an die Aufzeichnungselemente ein magnetisches Hilfsfeld angelegt, dessen Feldlinien senkrecht zur Oberfläche der Aufzeichnungsschichten (B) ausgerichtet sind, oder aber die Aufzeichnungsschichten (B) weisen ein entsprechend ausgerichtetes schichtimmantes (intrinsisches) Magnetfeld auf.

Bekanntermaßen werden die aus amorphen ferrimagnetischen Lanthanid-Übergangsmetall-Legierungen bestehenden, senkrecht zu ihrer Oberfläche magnetisierten Aufzeichnungsschichten (B) beim Einschreiben der Daten durch den Laserstrahl in der Auftreffstelle erwärmt. Durch die Erwärmung nimmt die Koerzitivfeldstärke $H_c$ der Legierungen ab. Unterschreitet die Koerzitivfeldstärke $H_c$ bei einer von der jeweils verwendeten Legierung abhängigen kritischen Temperatur die Feldstärke des anliegenden (externen) magnetischen Hilfsfeldes oder des intrinsischen Magnetfeldes, so entsteht in der Auftreffstelle ein Bereich, der eine der ursprünglichen Richtung entgegengesetzte Magnetisierungsrichtung aufweist. Ein solcher Bereich wird auch als "spot" bezeichnet.

Die eingeschriebenen Daten können gezielt durch lokales Erhitzen der beschriebenen Aufzeichnungsschicht (B), z.B. mittels eines Laserstrahls in einem externen oder intrinsichen Magnetfeld, dessen Feldlinien zur Schichtoberfläche ausgerichtet sind, bei Bedarf wieder gelöscht werden, wonach man neue Daten einschreiben kann. D.h. der Schreibvorgang ist reversibel.

Für das Lesen der Daten verwendet man linear polarisiertes Licht eines kontinuierlich emittierenden Dauerstrichlasers, dessen Lichtleistung nicht dazu ausreicht, das Material über die kritische Temperatur hinaus zu erwärmen. Dieser Laserstrahl wird entweder von der Aufzeichnungsschicht (B) selbst oder von einer hinter ihr angeordneten Reflektionsschicht reflektiert, wobei es zu einer Wechselwirkung zwischen den magnetischen Momenten in der Aufzeichnungsschicht (B) und dem magnetischen Vektor der Laserlichtquelle kommt. Durch diese Wechselwirkung wird die Ebene der Polarisation E des Laserlichts, welches von einem "spot" oder von einer dahinterliegenden Reflektionsschicht reflektiert wird, gegenüber der ursprünglichen Ebene um einen kleinen Winkel gedreht. Erfolgt diese Drehung der Ebene der Polarisation E bei der Reflektion des Lichts an der Aufzeichnungsschicht (B) selbst, so bezeichnet man dies als Kerr-Effekt und den Drehwinkel demnach als Kerr-Drehwinkel; wird dagegen die Ebene beim zweimaligen Durchgang des Lichts durch die Aufzeichnungsschicht (B) gedreht, so spricht man vom Faraday-Effekt und vom Faraday-Drehwinkel.

Diese Drehung der Ebene der Polarisation E des vom magneto-optischen Aufzeichnungselement reflektierten Laserlichts wird mit Hilfe geeigneter optischer und elektronischer Geräte gemessen und in Signale umgesetzt.

Wenn bei den bekannten magneto-optischen Aufzeichnungselementen beim Lesen der Daten der Faraday-Effekt ausgenutzt wird, so müssen die Aufzeichnungselemente notwendigerweise eine Reflektionsschicht enthalten, da die Aufzeichnungsschichten (B) als solche lichtdurchlässig sind. Überdies müssen Interferenzschichten vorhanden sein, um störende Beugungserscheinungen zu unterdrücken. Selbstverständlich wirken die in den bekannten magneto-optischen Aufzeichnungselemente vorhandenen Interferenzschichten und Reflektionsschichten sowie deren Kombination als auch Diffusionssperren, welche in gewissem Umfang verhindern, daß die äußerst sauerstoff- und wasserempfindliche Aufzeichnungsschicht (B) korrodiert. Sie erfüllen diese Funktion indes nicht in einem für die Praxis ausreichenden Maß, weil ihr Aufbau und ihre Zusammensetzung nicht ausschließlich von ihrer Diffusionssperrwirkung oder Antikorrosionswirkung, sondern in der Hauptsache von den anderen Funktionen bestimmt werden. Es müssen deshalb stets noch zusätzlich Antikorrosionsschichten (C) mitverwendet werden, welche das magneto-optische Aufzeichnungselement gegen die Luft hin abschließen.

Hinsichtlich ihrer Haftung auf den in den bekannten magneto-optischen Aufzeichnungselements enthaltenen sonstigen Schichten, ihrer Haltbarkeit, ihrer inneren Spannung oder ihrer mechanischen Festigkeit weisen die bisher bekannten Antikorrosionsschichten (C) jedoch noch immer Nachteile auf.

Hier wurde allerdings durch die in EP-A-0 326 932 beschriebene Antikorrosionsschicht (C) ein bedeutsamer Fortschritt erzielt, denn diese Antikorrosionsschicht (C) ist kratzfest, hart, haftfest, mechanisch fest und hinreichend spannungsfrei und sie schirmt die äußerst luft- und wasserempfindliche Aufzeichnungsschicht (B) von magneto-optischen Aufzeichnungselementen hervorragend ab. Desgleichen kann sie als optisch transparente Interferenzschicht zwischen dem Träger (A) und der Aufzeichnungsschicht (B) verwendet werden, und ist hierbei in ihrer optischen Anpassungswirkung anderen Interferenzschichten eindeutig überlegen, wobei ihre antikorrosive Wirkung auch in dieser Verwendung voll zum tragen kommt. Hinzu kommt noch, daß sie in ihren optischen und mechanischen Eigenschaften sowie in ihren Haftungseigenschaften den übrigen Schichten der magneto-optischen Aufzeichnungselemente gut angepaßt werden kann.

Wie vorstehend beschrieben, wird mit Hilfe der dünnen röntgenamorphen Germanium und Stickstoff enthaltenden Schicht der US-A-4 661 420 eine Erhöhung des Kerr-Drehwinkels erzielt. Indes geht aus der Patentschrift nicht hervor, ob dies auch für den Faraday-Drehwinkel zutrifft. Außerdem läßt die Antikorrosionswirkung der dünnen röntgenamorphen Schicht der US-A-4 661 420 erheblich zu wünschen übrig, insbesondere dann, wenn sie das magneto-optische Aufzeichnungselement gegen die Luft hin abschirmen soll.

Aufgabe der vorliegenden Erfindung ist es, neue polykristalline, unorientierte oder röntgenamorphe Carbid-, Oxid- und/oder Nitridkeramiken bereitzustellen, welche sich in der Form dünner Schichten ganz allgemein als Diffusionssperren oder als Interferenzschichten in optischen Anordnungen oder zum Schutz von empfindlichen Oberflächen vor Korrosion oder mechanischem Abrieb eignen. Insbesondere sollen sich die neuen polykristallinen, unorientierten oder röntgenamorphen Keramiken in der Form dünner Schichten für den Schutz magneto-optischer Aufzeichnungsschichten vor der Korrosion eignen, ohne hierbei die Nachteile des Standes der Technik aufzuweisen.

Überraschenderweise konnte die Aufgabe der Erfindung durch polykristalline, unorientierte oder röntgenamorphe Carbid-, Oxid- und/oder Nitridkeramiken des Germaniums gelöst werden, welche neben Germanium sowie Kohlenstoff, Sauerstoff und/ oder Stickstoff noch weitere Elemente in genau definierten Mengen enthalten, wobei es im Hinblick auf den Stand der Technik nicht zu erwarten war, daß gerade die neuen Keramiken des Germaniums mit ihrer speziellen Zusammensetzung die vorstehend beschriebenen Nachteile nicht mehr länger aufweisen und darüber hinaus auch noch zusätzliche Vorteile mit sich bringen.

Demnach handelt es sich bei dem Gegenstand der vorliegenden Erfindung um die eingangs definierten polykristallinen, unorientierten oder röntgenamorphen Carbid- Oxid- und/oder Nitridkeramiken des Germaniums, welche von der Elementzusammensetzung I gebildet werden, und welche im folgenden der Kürze halber als "erfindungsgemäße Keramik(en)" bezeichnet werden.

Die erfindungsgemäße Keramik ist vorteilhafterweise optisch transparent, d.h., daß sie z.B. Laserlicht weder streut noch in einem größeren Ausmaß absorbiert, sondern das betreffende Laserlicht ohne wesentliche Änderung der Intensität und des Strahlquerschnitts passieren läßt.

Die erfindungsgemäße Keramik ist entweder polykristallin, unorientiert oder röntgenamorph.

Hierbei ist die polykristalline oder unorientierte erfindungsgemäße Keramik aus Kristalliten (Mikrokristallen) aufgebaut, deren Größe zwar im Nanometerbereich liegt, welche indes noch immer Röntgenstrahlung zu beugen vermögen, wobei in der unorientierten erfindungsgemäßen Keramik keine Verzugsorientierung der Kristallite mehr vorliegt.

Dagegen liefert die röntgenamorphe erfindungsgemäße Keramik bei der Strahlen mit Röntgenstrahlung keine Beugungsbilder mehr und gleicht in dieser Hinsicht dem bekanntermaßen amorphen Glas.

Die polykristalline oder unorientierte erfindungsgemäße Keramik entspricht in ihren optischen und anwendungstechnischen Eigenschaften sowie in ihrer besonderen vorteilhaften Wirkung weitgehend der röntgenamorphen erfindungsgemäßen Keramik, wobei sich in Abhängigkeit vom Verwendungszweck gewisse Unterschiede ergeben können, die indes vorteilhaft nutzbar sind.

Ihrer Natur nach entspricht die erfindungsgemäße Keramik einem keramischen Material im üblichen Sinne, worunter man früher anorganische technische Produkte oder Werkstoffe verstanden hat, die durch Glühen ("Brennen") von Materialien wie Tonen u.a. erhalten werden und die eine hohe physikalische und chemische Stabilität aufweisen. Die Bedeutung dieses Begriffs ist in den letzten Jahren wegen der stürmischen Entwicklung auf dem Gebiet der anorganischen technischen Werkstoffe erheblich erweitert worden und er umfaßt nun auch Materialien, welche nicht durch Glühen oder Brennen, sondern mittels anderer Methoden hergestellt werden. Diese Materialien weisen ein Eigenschaftsprofil auf, welches dasjenige klassischer Keramiken in vieler Hinsicht übertrifft und oftmals ungewöhnliche Eigenschaften mit einschließt. Diese Materialien werden daher häufig als "modern ceramics" bezeichnet. Die erfindungsgemäße Keramik ist ein neuer Vertreter dieser "modern ceramics".

Die erfindungsgemäße Keramik ist ihrer Zusammensetzung nach als Carbid-, Oxid- und/oder Nitridkeramik aufzufassen, d.h. sie besteht entweder aus Carbiden, Oxiden oder Nitriden oder sie besteht aus Mischungen von Carbiden mit Nitriden, Oxiden mit Carbiden, Carbiden mit Nitriden oder von Oxiden und Carbiden mit Nitriden. Sie wird von der erfindungsgemäß zu verwendenden Elementzusammensetzung I gebildet, welche das Molverhältnis, in welchem die übrigen Komponenten außer Kohlenstoff, Sauerstoff und/oder Stickstoff zueinander stehen, im Überblick wiedergibt. Dieses Atom- oder Molverhältnis ist für eine gegebene erfindungsgemäße Keramik von vornherein ganz oder weitgehend festgelegt. Dagegen variiert das Molverhältnis von Kohlenstoff, Sauerstoff und/cder von Stickstoff zur Elementzusammensetzung I je nach vorgegebener Elementzusammensetzung I in der von der Wertigkeit der Atome und/oder von der Anzahl der vorhandenen elektrisch positiven oder elektrisch negativen Ladungen zwingend vorgeschriebenen Weise. Somit läßt sich der Kohlenstoff-, Sauerstoff- und/oder der Stickstoffgehalt einer erfindungsgemäßen Keramik über die jeweils verwendete Elementzusammensetzung I leicht berechnen, weswegen sich im folgenden die genaue Angabe des jeweiligen Kohlenstoff-, Sauerstoff- und/oder Stickstoffgehalts erübrigt und die pauschale Angabe, daß es sich beispielsweise um eine erfindungsgemäße Oxid- oder Nitridkeramik oder um eine erfindungsgemäße Oxid- und Nitridkeramik eines bestimmten Sauerstoff/Stickstoff-Verhältnisses handelt, für die vollständige stoffliche Charakterisierung der betreffenden erfindungsgemäßen Keramik ausreicht.

Die erfindungsgemäß zu verwendende Elementzusammensetzung I enthält die Komponente Germanium. Darüber hinaus enthält die Elementzusammensetzung I die Komponente M. Hierbei handelt es sich um mindestens ein weiteres Element, welches aus der Gruppe Titan, Zirkon, Hafnium, Thorium, Scandium, Yttrium, Lanthan, Cer, Praseodym, Neodym, Samarium, Europium, Gadolinium, Terbium, Dysprosium, Holmium, Erbium, Thulium, Ytterbium, Luthetium, Vanadin, Niob, Tantal, Chrom, Molybdän, Wolfram, Mangan, Rhenium, Eisen, Cobalt, Nickel, Ruthenium, Rhodium, Kupfer, Zink, Magnesium, Kalzium, Strontium, Barium, Bor, Aluminium, Gallium, Indium, Thallium, Zinn, Blei, Phosphor, Arsen, Antimon, Wismut und Tellur ausgewählt wird.

Hierbei kann die erfindungsgemäß zu verwendende Elementzusammensetzung I lediglich eines dieser Elemente M enthalten. Es ist indes von Vorteil, wenn die erfindungsgemäß zu verwendende Elementzusammensetzung I zwei oder drei dieser Elemente M enthält, weil dann das anwendungstechnische Eigenschaftsprofil der erfindungsgemäßen Keramiken, welche aus den betreffenden Elementzusammensetzungen I resultieren, in besonders einfacher und vorteilhafter Weise speziellen Anwendungszwecken angepaßt werden kann. In weniger häufigen Fällen kann es sich empfehlen mehr als drei, beispielsweise vier, fünf, sechs oder sieben, Elemente M in die erfindungsgemäß zu verwendende Elementzusammensetzung I einzubringen, woraus indes nur noch eine vergleichsweise geringe weitere Verbesserung des ohnedies schon hervorragenden anwendungstechnischen Eigenschaftsprofils der erfindungsgemäßen Keramiken resultiert.

Erfindungsgemäß besonders bevorzugt verwendete Elementzusammensetzungen I enthalten Scandium, Yttrium, Lanthan, Aluminium und/oder Silicium, weil die erfindungsgemäßen Keramiken auf der Grundlage dieser Elementzusammensetzungen I ganz besonders gut für die Herstellung von Antikorrosionsschichten (C) für magneto-optische Aufzeichnungselemente geeignet sind.

In den erfindungsgemäß zu verwendenden Elementzusammensetzungen I stehen Germanium und die Komponenten M in einem bestimmten Molverhältnis zueinander, was im Index x der eingangs aufgeführten allgemeinen Formel I zum Ausdruck kommt. Hierbei kann der Index x eine beliebige positive Zahl zwischen 0,01 und 0,7 sein. Zwar ist es möglich, daß der Index x Werte von größer als 0,7, beispielsweise 0,75 oder 0,85 annimmt, indes genügen die Germanium-haltigen Keramiken, welche aus den betreffenden Elementzusammensetzungen resultieren, nicht mehr in vollem Umfang den Ansprüchen der Praxis. Erfindungsgemäß ist es von Vorteil, wenn der Index x eine beliebige positive Zahl zwischen 0,05 und 0,5, insbesondere 0,1 bis 0,4 bezeichnet, weil die erfindungsgemäß zu verwendenden Elementzusammensetzungen 1 mit diesen Molverhältnissen erfindungsgemäße Keramiken liefern, welche besonders breit anwendbar sind, wobei sie in den unterschiedlichsten Anwendungsformen ihre besonderen Vorteile zeigen.

Beispiele erfindungsgemäß ganz besonders bevorzugt verwendeter Elementzusammensetzungen I sind der folgenden Zusammenstellung zu entnehmen:

Zusammenstellung:

I-1 $Ge_{0,7}Al_{0,2}Sc_{0,1}$
I-2 $Ge_{0,8}Al_{0,15}Y_{0,05}$
I-3 $Ge_{0,9}Al_{0,08}Si_{0,02}$
I-4 $Ge_{0,95}Al_{0,04}La_{0,02}$
I-5 $Ge_{0,75}Si_{0,2}Y_{0,094}La_{0,01}$
I-6 $Ge_{0,85}Al_{0,1}Sc_{0,03}Y_{0,02}$
I-7 $Ge_{0,9}Al_{0,05}Sc_{0,02}La_{0,03}$
I-8 $Ge_{0,8}Al_{0,15}Y_{0,02}La_{0,03}$
I-9 $Ge_{0,85}Al_{0,08}Si_{0,04}La_{0,03}$
I-10 $Ge_{0,75}Si_{0,2}Sc_{0,03}La_{0,02}$
I-11 $Ge_{0,785}Si_{0,2}Y_{0,05}$

Die erfindungsgemäße Keramik kann in den unterschiedlichsten äußeren Formen angewandt werden, z.B. als massive Kugeln, Ringe, Zylinder, Blöcke oder sonstige Formteile, deren Form und Aufbau sich nach dem jeweiligen Anwendungszweck richten. Ganz besondere Vorteile offenbart die erfindungsgemäße

5

Keramik indes in der erfindungsgemäß ganz besonders bevorzugten Ausführungsform einer dünnen Schicht.

Hierbei können die neuen dünnen Schichten aus den erfindungsgemäßen Keramiken in unterschiedlicher Weise aufgebaut sein. Besteht eine solche neue dünne Schicht beispielsweise aus Oxiden und Nitriden, so können der Sauerstoff und Stickstoff in statistischer Verteilung in der betreffenden neuen dünnen Schicht vorliegen, d.h. die Schicht ist homogen, wobei sie polykristallin, unorientiert oder röntgenamorph sein kann. Daneben kann die neue dünne Schicht auch eine Oxid/Nitrid-Keramik sein, worin Mikrokristalle aus Oxiden neben Mikrokristallen aus Nitriden in statistischer Verteilung nebeneinander vorliegen, d.h. die betreffende neue dünne Schicht ist ein polykristallines Gemenge. Das gilt sinngemäß auch für neue dünne Schichten, welche aus Oxiden und Carbiden, Carbiden und Nitriden oder aus Oxiden, Carbiden und Nitriden bestehen.

Die polykristallinen, unorientierten oder röntgenamorphen neuen dünnen Schichten können aber auch beispielsweise hinsichtlich der Verteilung des Sauerstoffs und Stickstoffs über die Schichtdicke hinweg einen Gradienten aufweisen. Dies bedeutet, daß die Konzentration des Stickstoffs, ausgehend von einer Seite der neuen dünnen Schicht zu der anderen Seite hin, gleichmäßig zunehmen kann, wobei dann die Konzentration des Sauerstoffs in entsprechender, durch die Stöchiometrie zwingend festgelegter Weise abnimmt. Dies kann aber auch bedeuten, daß die Konzentration des Stickstoffs, ausgehend von einer Seite der neuen dünnen Schicht, zunächst zunehmen kann, um dann wieder allmählich, d.h. fließend, oder abrupt abzunehmen, wobei auch hier die Konzentration des Sauerstoffs in entsprechender Weise ab- und anschließend wieder zunimmt. Letzteres kann über die gesamte Dicke der neuen dünnen Schicht hinweg mehrmals der Fall sein, wodurch ein mehrlagiger Aufbau der betreffenden Schicht resultiert. Das gilt sinngemäß auch für die neuen dünnen Schichten, welche aus Oxiden und Carbiden, Carbiden und Nitriden oder aus Oxiden, Carbiden und Nitriden bestehen.

Diese mehrlagigen neuen dünnen Schichten können demnach aus zwei oder mehr separaten Lagen bestehen, wobei es sich bei einer separaten Lage jeweils um eine Carbid-, Nitrid- oder Oxidlage oder um eine Carbid/Oxid-, Carbid/Nitrid-, Oxid/Nitrid- oder Carbid/Oxid/Nitridlage handeln kann.

Hierbei genügen in den allermeisten Fällen drei bis fünf separate Lagen für die Einstellung eines optimalen Eigenschaftprofils, in besonderen Fällen können aber neue dünne Schichten aus sechs, sieben oder acht Lagen verwendet werden. Die neuen dünnen Schichten aus neun, zehn oder mehr Lagen werden seltener angewendet, weil hierbei der höhere Herstellaufwand nicht in allen Fällen durch eine weitere Steigerung der an sich schon besonders vorteilhaften Eigenschaften gerechtfertigt wird. Von besonderem Vorteil sind daher neue dünne Schichten aus drei bis fünf Lagen, weil sie mit vergleichsweise geringem Aufwand herzustellen sind und dabei bereits optimale Eigenschaften aufweisen.

Die Lagen in diesen neuen dünnen Schichten können unterschiedliche Dicken aufweisen. Von Vorteil ist es indes, wenn sie in etwa von gleicher Dicke sind.

Außerdem kann der Übergang von einer Lage zur anderen abrupt sein, d.h., daß sich zwischen den Lagen eine exakt definierte Grenzfläche befindet, wie etwa beim Übergang von einer stöchiometrisch zusammengesetzten Nitrid-in eine Oxid- oder Carbidlage. Der Übergang kann aber auch fließend sein. So kann z.B. eine stöchiometrisch zusammengesetzte Nitridlage über eine Zone, in welcher die Konzentration des Stickstoffs mehr oder weniger rasch abnimmt und die Konzentration des Sauerstoffs oder des Kohlenstoffs mehr oder weniger rasch zunimmt, in eine reine Oxid- oder eine reine Carbidlage übergehen.

Erfindungsgemäß von Vorteil ist hierbei der fließende Übergang von einer Lage in die nächste.

Unabhängig davon, ob man eine polykristalline, unorientierte oder röntgenamorphe, ein- oder mehrlagige neue dünne Schicht aus Nitriden, Carbiden-und/oder Oxiden der erfindungsgemäß zu verwendenden Elementzusammensetzung I verwendet, ist es erfindungsgemäß von besonderem Vorteil, wenn diejenige Seite der betreffenden neuen dünnen Schicht, welche einer Oberfläche, beispielsweise der Oberfläche einer zu schützenden magneto-optischen Aufzeichnungsschicht (B), zugewandt ist oder direkt an diese angrenzt, hauptsächlich oder ausschließlich aus Nitriden besteht.

Unabhängig davon, ob man eine polykristalline, unorientierte oder röntgenamorphe, ein- oder mehrlagige dünne Schicht aus Nitriden und Oxiden, Carbiden und Oxiden, Nitriden und Carbiden oder aus Carbiden, Oxiden und Nitriden oder eine polykristalline oder röntgenamorphe neue dünne Schicht aus Carbiden, Oxiden oder Nitriden verwendet, ist die neue dünne Schicht bis zu 1000 nm dick. Wegen ihrer besonderen Eigenschaften und technischen Effekte, welche sich aus den erfindungsgemäßen Keramiken ergeben, erübrigen sich höhere Schichtdicken. Überdies ist mit dem hierfür notwendigen höheren Materialverbrauch nur noch eine vergleichsweise geringe weitere Steigerung des ohnedies schon vorteilhaften Eigenschaftsprofils verbunden. Die Dicke der neuen dünnen Schichten soll andererseits 20 nm nicht unterschreiten, weil dann beispielsweise ihre Sperrwirkung gegenüber Sauerstoff und Wasser nicht mehr in vollem Umfang befriedigt. Von Vorteil sind Dicken von 30 bis 800 nm, wobei der Dickenbereich von 30 bis 500 besonders und der Bereich von 40 bis 250 nm ganz besonders hervorzuheben ist. Innerhalb des Dickenbereichs von 40 bis 250 nm wiederum kommt dem Bereich von 40 bis 100 nm eine besondere Bedeutung zu, weil neue dünne Schichten dieser Dicke hinsichtlich der Sperrwirkung, des Materialverbrauchs, des Herstellaufwands, der mechanischen Festigkeit, der Zähigkeit und der Haltbarkeit ein optimales Eigenschaftsprofil und somit eine besonders gute Anwendbarkeit aufweisen. Demnach stellt der Bereich von 40 bis 100 nm ein Optimum dar, innerhalb dessen die Dicke der neuen dünnen Schicht variiert und in vorteilhafter Weise den stofflichen und technischen Parametern von z.B. magneto-optischen Aufzeichnungselementen vorzüglich angepaßt werden kann.

Unabhängig davon, ob man 20 bis 1000 nm dicke, polykristalline, unorientierte oder röntgenamorphe, ein- oder mehrlagige neue dünne Schichten aus Nitriden und Oxiden, Carbiden und Oxiden, Nitriden und Carbiden oder aus Carbiden, Oxiden und Nitriden oder 20 bis 1000 nm dicke, polykristalline, unorientierte oder röntgenamorphe neue dünne Schichten aus Carbiden, Oxiden oder Nitriden verwendet, wird die erfindungsgemäße Carbid-, Oxid- und/oder Nitridkeramik dieser neuen dünnen Schichten stets von der erfindungsgemäß zu verwendenden Elementzusammensetzung I gebildet.

Dies bedeutet, daß die erfindungsgemäßen Keramiken, aus denen die neuen dünnen Schichten bestehen, bezüglich der Elementzusammensetzung I über ihr gesamtes Volumen hinweg einen gleichmäßigen oder weitgehend gleichmäßigen Aufbau haben, d.h. die neuen dünnen Schichten sind hinsichtlich ihrer Elementzusammensetzung I frei oder weitgehend frei von Konzentrationsgradienten.

Methodisch weist die Herstellung der neuen erfindungsgemäßen Keramik keine Besonderheiten auf, sondern sie erfolgt nach den üblichen und bekannten Techniken der Herstellung von sogenannten "modern ceramics". Erfindungsgemäß bevorzugt ist die Herstellung der erfindungsgemäßen Keramik in ihrer besonders vorteilhaften Ausführungsform der dünnen Schicht. Auch die Herstellung der neuen dünnen Schichten weist methodisch keine Besonderheiten auf, sondern sie erfolgt nach den üblichen und bekannten Techniken der Herstellung dünner Carbid-, Oxid- und/oder Nitridkeramikschichten durch Aufdampfen, reaktives Aufdampfen, Ionenplattieren ("Ionplating"), "ion cluster beam deposition" (ICB), Kathodenzerstäubung ("sputtering") oder reaktive Kathodenzerstäubung ("reactive sputtering"). Von diesen Techniken wird die reaktive Kathodenzerstäubung mit Vorteil und die reaktive Magnetronkathodenzerstäubung ("reactive magnetron sputtering") mit ganz besonderem Vorteil angewendet.

Bei der reaktiven Kathodenzerstäubung wird bekanntermaßen das Material einer Kathode ("target") durch Beschuß mit Helium-, Neon-, Argon-, Krypton- und/oder Xenonionen in Vakuum in die Gasphase überführt (zerstäubt). Dem in dieser Weise resultierenden Gas werden weitere Komponenten - z.B. Kohlenwasserstoffe, Sauerstoff und/oder Stickstoff - zugemischt, welche zusammen mit dem zerstäubten Kathodenmaterial das Prozessgas bilden. Aus diesem Prozessgas wird das zerstäubte Kathodenmaterial zusammen mit den reaktiven Komponenten auf der zu beschichtenden Oberfläche als dünne Keramikschicht niedergeschlagen. Bei der reaktiven Magnetronkathodenzerstäubung befindet sich das "target" bekanntermaßen in einem Magnetfeld.

Durch die Variation von Verfahrensparametern wie Zerstäubungs- und Abscheiderate sowie Prozeßgasdruck und Zusammensetzung können dann dünne neue Schichten aus erfindungsgemäßen Keramiken der gewünschten Zusammensetzung ganz gezielt und sehr exakt polykristallin, unorientiert oder röntgenamorph hergestellt werden. Die Auswahl geeigneter Verfahrensparameter kann aufgrund der vorhandenen Fachkenntnisse auf dem Gebiet der reaktiven (Magnetron)Kathodenzerstäubung und/oder anhand von Vorversuchen getroffen werden.

Erfindungsgemäß werden für die Herstellung der neuen dünnen Schichten Kathoden ("targets") verwendet, welche die erfindungsgemäß zu verwendende Elementzusammensetzung I aufweisen. Die Kathoden haben die Form flacher Scheiben oder Platten und werden durch inniges Vermischen, Homogenisieren und Formen aus Germanium und den vorstehend beschriebenen Komponenten M mit Hilfe der üblichen und bekannten Misch- und Formungstechniken hergestellt.

Beispiele ganz besonders gut geeigneter Kathodenzusammensetzungen I sind die Elementzusammensetzungen I-1 bis I-11 der vorstehend aufgeführten Zusammenstellung.

Erfindungsgemäß ist es von besonderem Vorteil, diese Kathoden- der Elementzusammensetzung I in einer Vakuumatmosphäre zu zerstäuben, in welcher das Volumenverhältnis von Edelgas zu den reaktiven Gasen bei 1:5 bis 100:1 liegt, wobei man als Edelgas mindestens ein Edelgas aus der Gruppe Neon, Argon, Krypton und Xenon oder vorteilhafterweise ein Gemisch aus Argon und mindestens einem Edelgas aus der Gruppe Neon, Krypton und Xenon, worin das Volumenverhältnis von Argon zu dem oder den anderen Edelgas(en) bei 1:5 bis 10:1 liegt, verwendet. Vorteilhaft ist ferner, wenn das Prozessgas Wasserstoff enthält, weil in vielen Fällen die Anwesenheit des Wasserstoffs den Verfahrenserfolg weiter verbessert. Sofern Wasserstoff mitverwendet wird, liegt das Volumenverhältnis der reaktiven Gase zu Wasserstoff bei 2:1 bis 20:1.

Die erfindungsgemäße Keramiken, insbesondere in der Form der dünnen neuen Schichten sind hervorragend als Diffusionssperren, Antikorrosionsschichten oder Interferenzschichten oder zum Schutz empfindlicher Oberflächen vor mechanischem Abreib geeignet. Insbesondere dienen sie dem Schutz der äußerst luft- und wasserempfindlichen Aufzeichnungsschichten (B) von neuen magneto-optischen Aufzeichnungselementen vor Korrosion. In dieser Funktion werden die neuen dünnen Schichten als neue Antikorrosionsschichten (C) bezeichnet. Sie stellen den erfindungsgemäß wesentlichen Bestandteil der neuen magneto-optischen Aufzeichnungselemente dar. Ihre Herstellung erfolgt nach den vorstehend beschriebenen Methoden im Rahmen der Herstellung der neuen magneto-optischen Aufzeichnungselemente, wobei sich die Abfolge der einzelnen Verfahrensschritte zwingend aus dem gewünschten Aufbau des jeweils herzustellenden neuen magneto-optischen Aufzeichnungselements ergibt.

Der weitere wesentliche Bestandteil des neuen magneto-optischen Aufzeichnungselements ist der optisch transparente dimensionsstabile Träger (A).

Vorteilhafte Träger (A) sind die üblichen und bekannten, scheibenförmigen, optisch klaren dimensionsstabilen Träger (A) eines Durchmessers von 90 oder 130 mm und einer Dicke von 1,2 mm. Sie bestehen im allgemeinen aus Glas oder aus Kunststoffen wie z.B. Polycarbonat, Polymethylmethacrylat, Polymethylpenten, Celluloseacetobutyrat oder aus Gemischen aus Poly(vinylidenfluorid) und Polymethylmethacrylat oder Polystyrol und Poly(2,6-dimethylpheny-1,4-ylen-ether). Hiervon sind die Träger (A) aus Kunststoffen besonders vorteilhaft.

Diejenige Oberfläche des dimensionsstabilen Trägers (A), welche der Aufzeichnungsschicht (B) zugekehrt ist, kann Strukturen aufweisen.

Die Strukturen in der Oberfläche des Trägers (A) liegen im Mikrometer-und/oder Submikrometerbereich. Sie dienen der exakten Führung des Leselaserstrahls und gewährleisten ein rasches und genaues Ansprechen der Spurlagenservo- und Autofokussiereinrichtungen in den laseroptischen Schreib- und Leseköpfen der Plattenlaufwerke, d.h. sie ermöglichen das "tracking". Außerdem können diese Strukturen selbst Daten sein, so wie dies beispielsweise bei den bekannten Audio- oder Video-Compact-Disks der Fall ist, oder sie können der Kodierung der eingeschriebenen Daten dienen. Die Strukturen bestehen aus erhabenen Teilen und/oder aus Vertiefungen. Diese liegen in der Form von durchgehenden konzentrischen oder spiralförmigen Spurrillen oder als isolierte Hügel und/oder Löcher vor. Außerdem kann die Struktur eine mehr oder wenige glatte Wellenform haben. Den Spurrillen wird hierbei der Vorzug gegeben. Sie weisen in ihrer Querrichtung eine rechteckige sägezahnartige, eine V-förmige oder eine trapezartige Kontur auf. Ihre Vertiefungen werden im allgemeinen als "grooves" und ihre erhabenen Teile als "land" bezeichnet. Von besonderem Vorteil sind Spurrillen mit 50 bis 200 nm tiefen und 0,4 bis 0,8 $\mu$m breiten "grooves", zwischen denen jeweils ein 1 bis 3 $\mu$m breites "land" liegt.

Die Herstellung des besonders bevorzugt verwendeten dimensionsstabilen Trägers (A) erfolgt in an sich bekannter Weise durch die formgebende Bearbeitung des den Träger (A) aufbauenden Kunststoffs oder Kunststoffgemischs mit Hilfe der Spritzgußtechnik unter Reinraumbedingungen, so wie dies beispielsweise im einzelnen in der deutschen Patentanmeldung P 37 27 093.1 beschrieben wird.

Ganz besonders bevorzugt werden in dieser Weise dimensionsstabile Träger (A) mit Spurrillen auf einer ihrer Oberfläche hergestellt.

Der weitere wesentliche Bestandteil des neuen magneto-optischen Aufzeichnungselements ist die magneto-optische Aufzeichungsschicht (B) aus einer amorphen Lanthanid-Übergangsmetall-Legierung. Die Aufzeichnungsschicht (B) ist 10 bis 500 nm dick. Für den Aufbau der Aufzeichnungsschicht (B) kommen die Lanthanide Pr, Nd, Sm, Eu, Gd, Tb, Dy und Ho und die Übergangsmetalle Fe und Co in Betracht. Geeignete Mischungsverhältnisse von Lanthaniden zu Übergangsmetallen sind vom Stand der Technik her bekannt. Darüber hinaus kann die amorphe Lanthanid-Übergangsmetall-Legierung noch weitere Elemente wie Sc, Y, La, V, Nb, Ta, Cr, Mo, W, Mn, Ni, Re, Ru, Os, Rh, Ir, Pd, Pt, Cu, Ag, Au, Zn, B, Al, Ga, In, Si, Ge, Sn, Pb, P, As, Sb und/oder Bi in üblichen und bekannten Mengen enthalten.

Im Rahmen der Herstellung des neuen magneto-optischen Aufzeichnungselements wird die Aufzeichnungsschicht (B) auf dem dimensionsstabilen Träger (A), vorteilhafterweise auf einer dem Träger (A) aufliegenden Schicht, mit Hilfe der vorstehend erwähnten Techniken zur Erzeugung der neuen dünnen Schichten hergestellt.

Darüber hinaus kann das neue magneto-optische Aufzeichnungselement weitere Schichten enthalten, welche für die Funktion des Aufzeichnungselements von Nutzen sind. Hierbei handelt es sich um die üblichen und bekannten Interferenzschichten, Reflektionsschichten oder Haftschichten oder um weitere magnetisierbare Schichten. Außerdem können zwei der neuen magneto-optischen Aufzeichnungselemente "sandwich"-artig miteinander verbunden werden, so daß ihre Aufzeichnungsschichten (B) einander zugekehrt sind und ein gewisser Abstand zwischen ihnen herrscht, wobei die üblichen und bekannten Techniken zum Verbindungen zweier Aufzeichnungselemente angewandt werden.

EP 0 410 337 A2

Üblicherweise wird in den Aufzeichnungsschichten (B) nach der Herstellung der neuen magneto-optischen Aufzeichnungselemente eine definierte, senkrecht zur Schichtoberfläche orientierte Magnetisierung induziert.

Das besonders bevorzugte neue magneto-optische Aufzeichnungselement ist die neue magneto-optische Datenplatte oder Disk mit

1. dem vorstehend beschriebenen, besonders bevorzugt verwendeten dimensionsstabilen Träger (A),

2. der ersten neuen Antikorrosionsschicht (C),

3. der vorstehend beschriebenen Aufzeichnungsschicht (B) und

4. der zweiten neuen Antikorrosionsschicht (C), sowie ggf. mit zusätzlichen üblichen und bekannten Schichten.

Die Herstellung der einzelnen Schichten dieser neuen magneto-optischen Datenplatte erfolgt nach den vorstehend beschriebenen Methoden, wobei sich die Reihenfolge der Verfahrensschritte zwingend aus dem Aufbau (A), (C), (B), (C) ergibt.

Die neuen magneto-optischen Aufzeichnungselemente können in üblicher Weise von der Seite des optisch transparenten dimensionsstabilen Trägers (A) her mit Hilfe eines impulsmodulierten, auf die Aufzeichnungsschichten (B) fokussierten und/oder senkrecht auf diese auftreffenden Schreiblaserstrahls einer Wellenlänge λ von kleiner als 1000 nm mit Daten in Form ummagnetisierter "spots" beschrieben werden. Hiernach können die Daten mit Hilfe eines auf die beschriebenen Aufzeichnungsschichten (B) fokussierten und/oder senkrecht auf sie auftreffenden Dauerstrichlaserstrahls gelesen werden, wobei man das von den Aufzeichnungsschichten (B) selbst oder das von den ggf. vorhandenen Reflektionsschichten reflektierte Licht erfaßt, analysiert und in Signale umwandelt. Im Falle der neuen magneto-optischen Datenplatten oder Disks können hierfür die üblichen und bekannten laseroptischen Plattenlaufwerke mit laseroptischen Köpfen, welche Halbleiterlaser enthalten, verwendet werden.

Die neuen magneto-optischen Aufzeichnungselemente weisen gegenüber dem Stand der Technik besondere Vorteile auf, welche sich letztlich aus der Verwendung der erfindungsgemäßen Keramik für den Aufbau der neuen Antikorrosionsschicht (C) ergeben. Sie haben eine höhere Empfindlichkeit als bekannte magneto-optische Aufzeichnungselemente, weswegen sie mit entsprechend geringerer Laserleistung beschrieben werden können. Die neuen magneto-optischen Datenplatten (Disks) können daher - bei gleicher Laserleistung - bei höheren Plattendrehzahlen beschrieben werden als bekannte Disks. Auch ihre Bitdichte ist gegenüber dem Stand der Technik deutlich erhöht. Beim Lesen liefern sie unverzerrte Signale und weisen ein Signal-Rausch-Verhältnis von mehr als 55 dB auf. Selbst nach einer Lagerzeit von mehr als 1000 Stunden bei 70°C und einer relativen Luftfeuchtigkeit von 90 % kommt es nicht zu einer Erhöhung der Bitfehlerrate ("bit error rate"), d.h. es tritt kein Informationsverlust auf.

Wie vorstehend beschrieben weisen die neuen magneto-optischen Aufzeichnungselemente zumindest eine neue Antikorrosionsschicht (C) auf, welche aus der erfindungsgemäßen Keramik besteht. Diese neue Antikorrosionsschicht (C) ist kratzfest, hart, haftfest, mechanisch fest und spannungsfrei und schirmt die äußerst luft- und wasserempfindliche Aufzeichnungsschicht (B) hervorragend ab. Wird die neue Antikorrosionsschicht (C) auch als optisch transparente Interferenzschicht zwischen dem Träger (A) und der Aufzeichnungsschicht (B) verwendet, so ist sie in ihrer optischen Anpassungswirkung herkömmlichen Interferenzschichten eindeutig überlegen. Hinzu kommt noch, daß die hervorragende antikorrosive Wirkung der neuen Antikorrosionsschicht (C) auch hier voll zum Tragen kommt. Ganz besondere Vorteile ergeben sich, wenn man beide Seiten der Aufzeichnungsschicht (B) mit der neuen Antikorrosionsschicht (C) bedeckt. Hierdurch wird vor allem die Lebensdauer der erfindungsgemäßen Aufzeichnungsmaterialien über die bislang erreichbare Zeit hinaus verlängert. Überdies hinaus macht es sich vorteilhaft bemerkbar, daß die neue Antikorrosionsschicht (C) hinsichtlich ihrer optischen und mechanischen Eigenschaften sowie ihrer Haftungseigenschaften den übrigen Schichten der neuen mangeto-optischen Aufzeichnungselemente in hervorragender und dennoch einfacher Weise angepaßt werden kann. Hierzu kommt noch, daß die neuen Antikorrosionsschicht (C) in ihrer Funktion als Interferenzschicht den Kerr- und den Faraday-Drehwinkel zu erhöhen vermag, was die neuen magneto-optischen Aufzeichnungselemente für die Praxis noch attraktiver macht.

Beispiele

In den folgenden Beispielen und Vergleichsversuchen werden die Herstellung und die besonderen technischen Vorteile der erfindungsgemäßen Keramiken im Rahmen der Herstellung und Verwendung der neuen magneto-optischen Aufzeichnungselemente im einzelnen beschrieben.

9

Beispiele 1 bis 22

Herstellung und anwendungstechnische Eigenschaften von neuen magneto-optischen Datenplatten

Es wurden als dimensionsstabile Träger (A) vierundvierzig 130 mm durchmessende, 1,2 mm dicke, mit Spurrillen versehene polycarbonatscheiben unter Reinraumbedingung durch Spritzgießen hergestellt.

Hiernach wurden unter Drehen der polycarbonatscheiben (A) (22 Stück, Beispiele 1 bis 22) auf ihre mit Spurrillen versehene Seite die einzelnen Schichten (B) und (C) in der gewünschten Anzahl, Reihenfolge und Dicke und mit dem jeweils gewünschten inneren Aufbau aus der Gasphase aufgebracht. Dabei erfolgte das Aufbringen der neuen Antikorrosionsschichten (C) durch reaktive Magnetronkathodenzerstäubung ("reactive magnetron sputtering") der betreffenden Elementzusammensetzungen I-1 bis I-11 im Vakuum und durch Beimengen der gewünschten Mengen an Kohlenwasserstoffen, Sauerstoff und/oder Stickstoff zum jeweiligen Prozeßgas. Dagegen wurden die Aufzeichnungsschichten (B) durch Kathodenzerstäubung eines aus Tb, Dy und Fe bestehenden "targets" erzeugt. Hierbei wurden die Verfahrensparameter so gewählt, daß sich die in der Tabelle 1 angegebenen Zusammensetzungen der neuen mangneto-optischen Datenplatten ergaben (Beispiele 1 bis 22).

Zur Überprüfung des Verfahrenserfolges und zu analytischen Zwecken wurden weitere 22 neuen magneto-optische Datenplatten unter jeweils exakt vergleichbaren Bedinungen hergestellt (Beispiele 1a bis 22a). Anhand dieser Datenplatten wurden die Morphologie und die stoffliche Zusammensetzung der neuen Antikorrosionsschichten (C), welche aus den erfindungsgemäßen Keramiken bestanden, mittels üblicher und bekannter, z. T. materialabbauender Analysenmethoden wie chemische Elementaranalyse, Lichtmikroskopie, Rasterelektronenmikroskopie, Röntgenspektroskopie, Röntgenstreuung, ESCA (Elektronenspektroskopie für die chemische Analyse) und Flammenphotometrie untersucht. Desweiteren wurde mit Hilfe der üblichen und bekannten, zerstörungsfreien optischen und spektroskopischen Methoden sichergestellt, daß die jeweiligen neuen Antikorrosionsschichten (C) der Beispielspaare (1, 1a) bis (22, 22a) jeweils miteinander identisch waren, so daß die anhand der Beispiele 1a bis 22a ermittelten stofflichen und morphologischen Parameter in die Tabelle 1 miteinfließen konnten.

Die Aufzeichnungsschichten (B) der neuen magneto-optischen Datenplatten der Beispiele 1 bis 22 wurden unmittelbar nach ihrer Herstellung senkrecht zu ihrer Oberfläche magnetisiert. Anschließend wurden die neuen magneto-optischen Datenplatten während 48 Stunden bei 23 ± 2 ° C bei einem Luftdruck von 103 ± 3,5 kPa und bei einer relativen Luftfeuchte von 45 bis 55 % konditioniert.

Hiernach wurden die konditionierten Datenplatten mit Hilfe eines üblichen und bekannten Plattenlaufwerks unter exakt vergleichbaren Bedingungen mit Daten beschrieben. Hierzu verwendete man einen impulsmodulierten GaAlAs-Halbleiterlaser, welcher linear polarisiertes Licht der Wellenlänge $\lambda$ = 830 nm emittierte. Sowohl die Bitlänge, d.h. der Durchmesser der ummagnetisierten "spots", als auch der Bitabstand, d.h. der Abstand von "spot" zu "spot", lagen bei etwa 1 $\mu$m.

Für das Lesen der eingeschriebenen Daten über den Kerr-Effekt (Beispiele 1 bis 11) oder über den Faraday-Effekt (Beispiele 12 bis 22) verwendete man den GaAlAs-Halbleiterlaser im Dauerstrich-Betrieb mit einer Lichtleistung von 2 mW. Die unkorrigierte Bitfehlerrate wurde in üblicher und bekannter Weise mittels eines Zeitintervallanalysators ("time interval analyzer", TIA) bestimmt.

Die neuen magneto-optischen Datenplatten wurden zunächst unmittelbar nach dem Beschreiben gelesen (1. Lesen). Hiernach wurden die Datenplatten dem für magneto-optische Aufzeichnungselemente typischen "beschleunigten Lebensdauertest" bei 60, 70 und 80 ° C bei einer relativen Luftfeuchtigkeit von 90 % unterworfen und danach erneut gelesen (2. Lesen). Aus den hierbei erhaltenen unkorrigierten Bitfehlerraten und aus der licht- und rasterelektronenmikroskopischen Begutachtung der Aufzeichnungsschichten (B) der neuen magneto-optischen Datenplatten wurde deren Lebensdauer unter Normalbedingungen (30 ° C, 90 % relative Luftfeuchtigkeit) abgeschätzt. Die betreffenden Ergebnisse finden sich in der Tabelle 2.

Vergleichsversuch V1

Herstellung und anwendungstechnische Eigenschaften eines aus der US-A-4 661 420 bekannten magneto-optischen Aufzeichnungselements

Nach der in der US-A-4 661 420, Spalte 6, Zeilen 18 bis 27, angegebenen Vorschrift wurde eine Vergleichsplatte des folgenden Aufbaues und der folgenden Zusammensetzung hergestellt:

- Träger (A): 1,2 mm dicke, 130 mm durchmessende Glasplatte;
- erste Schicht: $(GeSi)_{0,9}N_{0,1}$; röntgenamorph, 1-lagig, 120 nm;
- Aufzeichnungsschicht (B): TbFe, 100 nm;
- bekannte Antikorrosionsschicht: $SiO_2$, 100 nm.

Die Vergleichsplatte wurde, wie bei den Beispielen 1 bis 22 angegeben, magnetisiert, mit Daten beschrieben, gelesen und getestet. Die dabei erhaltenen Versuchsergebnisse werden in der Tabelle 2 mit den Werten aus den Beispielen 1 bis 22 verglichen.

Der Vergleich zeigt, daß dieses magneto-optische Aufzeichnungselement bekannter Zusammensetzung den neuen magneto-optischen Aufzeichnungselementen hinsichtlich der Lagerstabilität unterlegen war, was sich an seiner deutlich erhöhten Bitfehlerrate beim zweiten Lesen bemerkbar machte.

Tabelle 1 Aufbau und Zusammensetzung der neuen magneto-optischen Datenplatten

| Bei-spiel Nr. | erste neue Antikorrosions-schicht (C) | | Aufzeich-nungs-schicht(B) | zweite neue Anti-korrosionsschicht (C) | | Reflek-tions-schicht | dritte neue Antikorrosionsschicht (C) | |
|---|---|---|---|---|---|---|---|---|
| | Elementzusammen-setzung I und Morphologie | Atomverhält-nis O:N:C und Dicke (nm) | (nm) | Elementzusammen-setzung I und Morphologie | Atomverhält-nis O:N:C und Dicke (nm) | (nm) | Elementzusammen-setzung I und Morphologie | Atomverhält-nis O:N:C und Dicke (nm) |
| 1 | I-1 röntgenamorph 2-lagig | 1:2:0 (75) | TbDyFe (80) | I-1 röntgenamorph 1-lagig | 1:2,5:0 (50) | – | – | – |
| 2 | I-2 polykristallin 3-lagig | 1:3:0,1 (80) | TbDyFe (90) | I-2 polykristallin 4-lagig | 1:1:0 (70) | – | – | – |
| 3 | I-3 unorientiert 1-lagig | 1:20:0 (75) | TbDyFe (85) | I-3 röntgenamorph 1-lagig | 1:1:100 (45) | – | – | – |
| 4 | I-4 röntgenamorph 1-lagig | 15:1:0 (70) | TbDyFe (80) | I-4 röntgenamorph 2-lagig | 1:3:0 (80) | – | – | – |
| 5 | I-5 polykristallin 4-lagig | 1:1:0 (75) | TbDyFe (80) | I-5 röntgenamorph 1-lagig | 1:200:0 (70) | – | – | – |

Tabelle 1 Aufbau und Zusammensetzung der neuen magneto-optischen Datenplatten

| Bei-spiel Nr. | erste neue Antikorrosions-schicht (C) | | Aufzeich-nungs-schicht(B) | zweite neue Anti-korrosionsschicht (C) | | Reflek-tions-schicht | dritte neue Antikorrosionsschicht (C) | |
|---|---|---|---|---|---|---|---|---|
| | Elementzusammen-setzung I und Morphologie | Atomverhält-nis O:N:C und Dicke (nm) | (nm) | Elementzusammen-setzung I und Morphologie | Atomverhält-nis O:N:C und Dicke (nm) | (nm) | Elementzusammen-setzung I und Morphologie | Atomverhält-nis O:N:C und Dicke (nm) |
| 6 | I-6 polykristallin 1-lagig | 100:1:0 (70) | TbDyFe (80) | I-6 röntgenamorph 1-lagig | 150:1:0,1 (60) | – | – | – |
| 7 | I-7 polykristallin 4-lagig | 1:1:0,5 (80) | TbDyFe (80) | I-7 röntgenamorph 1-lagig | 150:1:0,1 (60) | – | – | – |
| 8 | I-8 röntgenamorph 1-lagig | 100:1:0 (70) | TbDyFe (90) | I-8 röntgenamorph 2-lagig | 1:1:0 (70) | – | – | – |
| 9 | I-9 unorientiert 1-lagig | nur O (75) | TbDyFe (80) | I-9 polykristallin 1-lagig | nur N (40) | – | – | – |
| 10 | I-10 polykristallin 1-lagig | 1:10:0 (70) | TbDyFe (75) | I-10 röntgenamorph 1-lagig | nur N (50) | – | – | – |

Tabelle 1 Aufbau und Zusammensetzung der neuen magneto-optischen Datenplatten

| Bei- spiel Nr. | erste neue Antikorrosions- schicht (C) | | Aufzeich- nungs- schicht(B) | zweite neue Anti- korrosionsschicht (C) | | Reflek- tions- schicht | dritte neue Antikorrosionsschicht (C) | |
|---|---|---|---|---|---|---|---|---|
| | Elementzusammen- setzung I und Morphologie | Atomverhält- nis O:N:C und Dicke (nm) | (nm) | Elementzusammen- setzung I und Morphologie | Atomverhält- nis O:N:C und Dicke (nm) | (nm) | Elementzusammen- setzung I und Morphologie | Atomverhält- nis O:N:C und Dicke (nm) |
| 11 | I-11 polykristallin 4-lagig | 200:1:0,1 (80) | TbDyFe (90) | I-11 röntgenamorph 1-lagig | nur N (60) | – | – | – |
| 12 | I-1 röntgenamorph 1-lagig | 100:1:0,2 (80) | TbDyFe (20) | I-1 röntgenamorph 1-lagig | nur O (100) | Al (500) | I-1 röntgenamorph 1-lagig | nur N (40) |
| 13 | I-2 polykristallin 1-lagig | 100:1:0 (80) | TbDyFe (25) | I-2 röntgenamorph 1-lagig | 100:1:0 (150) | Al (300) | I-2 röntgenamorph 1-lagig | nur N (50) |
| 14 | I-3 polykristallin 5-lagig | 1:1:0 (70) | TbDyFe (23) | I-3 röntgenamorph 1-lagig | nur O (100) | Al (350) | I-3 röntgenamorph 4-lagig | 1:2:0 (40) |
| 15 | I-4 polykristallin 1-lagig | nur O (80) | TbDyFe (30) | I-4 röntgenamorph 1-lagig | nur O (150) | Al (500) | I-4 unorientiert 5-lagig | 1:1:0 (60) |

EP 0 410 337 A2

Tabelle 1 Aufbau und Zusammensetzung der neuen magneto-optischen Datenplatten

| Bei-spiel Nr. | erste neue Antikorrosions-schicht (C) | | Aufzeich-nungs-schicht(B) | zweite neue Anti-korrosionsschicht (C) | | Reflek-tions-schicht | dritte neue Antikorrosionsschicht (C) | |
|---|---|---|---|---|---|---|---|---|
| | Elementzusammen-setzung I und Morphologie | Atomverhält-nis O:N:C und Dicke (nm) | (nm) | Elementzusammen-setzung I und Morphologie | Atomverhält-nis O:N:C und Dicke (nm) | (nm) | Elementzusammen-setzung I und Morphologie | Atomverhält-nis O:N:C und Dicke (nm) |
| 16 | I-5 polykristallin 1-lagig | nur O (70) | TbDyFe (22) | I-5 polykristallin 1-lagig | nur O (80) | Al (400) | I-5 polykristallin 1-lagig | 200:1:100 (80) |
| 17 | I-6 röntgenamorph 1-lagig | 1000:1:0 (75) | TbDyFe (20) | I-6 röntgenamorph 1-lagig | nur O (80) | Al (300) | I-6 polykristallin 3-lagig | 1:2:300 (40) |
| 18 | I-7 röntgenamorph 1-lagig | 1:1:0 (70) | TbDyFe (20) | I-7 röntgenamorph 1-lagig | 1:1 (95) | Al (300) | I-7 röntgenamorph 2-lagig | 1:1:0 (40) |
| 19 | I-8 unorientiert 1-lagig | 100:1:0 (80) | TbDyFe (25) | I-8 polykristallin 2-lagig | 3:1:0 (100) | Al (450) | I-8 polykristallin 1-lagig | nur C (60) |
| 20 | I-9 polykristallin 2-lagig | 50:1:0,1 (70) | TbDyFe (25) | I-9 unorientiert 1-lagig | 100:1:0 (100) | Al (300) | I-9 polykristallin 1-lagig | 1:100:0 (50) |

EP 0 410 337 A2

Tabelle 1 Aufbau und Zusammensetzung der neuen magneto-optischen Datenplatten

| Bei-spiel Nr. | erste neue Antikorrosions-schicht (C) | | Aufzeich-nungs-schicht(B) | zweite neue Anti-korrosionsschicht (C) | | Reflek-tions-schicht | dritte neue Antikorrosionsschicht (C) | |
|---|---|---|---|---|---|---|---|---|
| | Elementzusammen-setzung I und Morphologie | Atomverhält-nis O:N:C und Dicke (nm) | (nm) | Elementzusammen-setzung I und Morphologie | Atomverhält-nis O:N:C und Dicke (nm) | (nm) | Elementzusammen-setzung I und Morphologie | Atomverhält-nis O:N:C und Dicke (nm) |
| 21 | I-10 röntgenamorph 1-lagig | nur O (100) | TbDyFe (20) | I-10 polykristallin 1-lagig | nur O (90) | Al (300) | I-10 röntgenamorph 1-lagig | nur N (55) |
| 22 | I-11 röntgenamorph 2-lagig | 1:2:0 (70) | TbDyFe (27) | I-11 röntgenamorph 1-lagig | 1:1000 (100) | Al (350) | I-11 röntgenamorph 1-lagig | 1:1:1000 (40) |

EP 0 410 337 A2

Tabelle 2

| Versuchsergebnisse | | |
|---|---|---|
| Beispiel | Bitfehlerrate (unkorrigiert) | | Lebensdauer (Jahre) |
| | 1. Lesen | 2. Lesen | |
| 1 | $< 10^{-5}$ | $< 10^{-5}$ | $> 15$ |
| 2 | $< 10^{-5}$ | $< 10^{-5}$ | $> 15$ |
| 3 | $< 10^{-5}$ | $< 10^{-5}$ | $> 15$ |
| 4 | $< 10^{-5}$ | $10^{-5}$ | $\sim 15$ |
| 5 | $< 10^{-5}$ | $< 10^{-5}$ | $> 15$ |
| 6 | $10^{-5}$ | $10^{-5}$ | $\sim 15$ |
| 7 | $< 10^{-5}$ | $10^{-5}$ | $\sim 15$ |
| 8 | $10^{-5}$ | $10^{-5}$ | $\sim 15$ |
| 9 | $< 10^{-5}$ | $< 10^{-5}$ | $> 15$ |
| 10 | $< 10^{-5}$ | $< 10^{-5}$ | $> 15$ |
| 11 | $< 10^{-5}$ | $10^{-5}$ | $> 15$ |
| 12 | $< 10^{-5}$ | $< 10^{-5}$ | $> 15$ |
| 13 | $10^{-5}$ | $10^{-5}$ | $\sim 15$ |
| 14 | $< 10^{-5}$ | $< 10^{-5}$ | $> 15$ |
| 15 | $< 10^{-5}$ | $10^{-5}$ | $> 15$ |
| 16 | $10^{-5}$ | $10^{-5}$ | $> 15$ |
| 17 | $10^{-5}$ | $10^{-5}$ | $> 15$ |
| 18 | $< 10^{-5}$ | $< 10^{-5}$ | $> 15$ |
| 19 | $10^{-5}$ | $10^{-5}$ | $> 15$ |
| 20 | $< 10^{-5}$ | $10^{-5}$ | $\sim 15$ |
| 21 | $< 10^{-5}$ | $< 10^{-5}$ | $> 15$ |
| 22 | $< 10^{-5}$ | $10^{-5}$ | $\sim 15$ |
| Vgl. Vers. VI | $10^{-5}$ | $2 \cdot 10^{-4}$ | 10-11 |

**Ansprüche**

1. Polykristalline, unorientierte oder röntgenamorphe Carbid-, Oxid- und/oder Nitridkeramiken, welche von der Elementzusammensetzung I gebildet werden,

$Ge_{1-x}M_x$   (I)

worin der Index und die Variable die folgende Bedeutung haben:

M mindestens ein Element aus der Gruppe Titan, Zirkon, Hafnium, Thorium, Scandium, Yttrium, Lanthan, Cer, Praseodym, Neodym, Samarium, Europium, Gadolinium, Terbium, Dysprosium, Holmium, Erbium, Thulium, Ytterbium, Lutetium, Vanadin, Niob, Tantal, Chrom, Molybdän, Wolfram, Mangan, Rhenium, Eisen, Kobalt, Nickel, Ruthenium, Rhodium, Kupfer, Zink, Magnesium, Kalzium, Strontium, Barium, Bor, Aluminium, Gallium, Indium, Thallium, Silizium, Zinn, Blei, Phosphor, Arsen, Antimon, Wismut und Tellur;

x 0,01 bis 0,7.

2. Dünne Schichten, dadurch gekennzeichnet, daß sie aus einer polykristallinen, unorientierten oder röntgenamorphen Carbid-, Oxid-und/oder Nitridkeramik gemäß Anspruch 1 bestehen.

3. Verwendung der dünnen Schichten gemäß Anspruch 2 als Diffusionssperren, Antikorrosionsschichten oder Interferenzschichten.

4. Verwendung der dünnen Schichten gemäß Anspruch 2 zum Schutz von Oberflächen vor mechanischem Abrieb.

5. Verwendung der dünnen Schichten gemäß Anspruch 2 zum Schutz magneto-optischer Aufzeichnungsschichten vor Korrosion.

6. Magneto-optisches Aufzeichnungselement mit

A) einem optisch transparenten dimensionsstabilen Träger,

B) einer thermisch veränderbaren Aufzeichnungsschicht aus einer amorphen Lanthanid-Übergangsmetall-Legierung und - zumindest auf der dem Träger (A) abgewandten Seite der Aufzeichnungsschicht - mit

C) einer dünnen polykristallinen, unorientierten oder röntgenamorphen Schicht aus einer Carbid-, Oxid-und/oder Nitridkeramik,

dadurch gekennzeichnet, daß die dünne polykristalline, unorientierte oder röntgenamorphe Schicht (C) aus der Carbid-, Oxid- und/oder Nitridkeramik gemäß Anspruch 1 besteht.

7. Verfahren zur Herstellung einer dünnen polykristallinen, unorientierten oder röntgenamorphen Carbid-, Oxid- und/oder Nitridkeramikschicht auf einer Oberfläche durch reaktive Kathodenzerstäubung ("reactive sputtering") oder reaktive Magnetronkathodenzerstäubung ("reactive magnetron sputtering") einer Kathode ("target") im Vakuum in einer Edelgas und reaktive Gase enthaltenden Prozessgasatmosphäre und durch Abscheiden der betreffenden Keramikschicht aus der Gasphase, dadurch gekennzeichnet, daß man hierbei eine Kathode der Elementzusammensetzung I verwendet,

$Ge_{1-x}M_x$   I,

worin der Index und die Variable die folgende Bedeutung haben:

M mindestens ein Element aus der Gruppe Titan, Zirkon, Hafnium, Thorium, Scandium, Yttrium, Lanthan, Cer, Praseodym, Neodym, Samarium, Europium, Gadolinium, Terbium, Dysprosium, Holmium, Erbium, Thulium, Ytterbium, Lutetium, Vanadin, Niob, Tantal, Chrom, Molybdän, Wolfram, Mangan, Rhenium, Eisen, Kobalt, Nickel, Ruthenium, Rhodium, Kupfer, Zink, Magnesium, Kalzium, Strontium, Barium, Bor, Aluminium, Gallium, Indium, Thallium, Silizium, Zinn, Blei, Phosphor, Arsen, Antimon, Wismut und Tellur;

x 0,01 bis 0,7.

8. Das Verfahren nach Anspruch 7, dadurch gekennzeichnet, daß das Volumenverhältnis von Edelgas zu den reaktiven Gasen bei 1:5 bis 100:1 liegt.

9. Das Verfahren nach Anspruch 7 oder 8, dadurch gekennzeichnet, daß man hierbei als Edelgas mindestens ein Edelgas aus der Gruppe Neon, Argon, Krypton und Xenon verwendet.

10. Das Verfahren nach einem der Ansprüche 7 bis 9, dadurch gekennzeichnet, daß man hierbei als Edelgas ein Gemisch aus Argon und mindestens einem Edelgas aus der Gruppe Neon, Krypton und Xenon verwendet, worin das Volumenverhältnis von Argon zu dem oder den anderen Edelgas(en) bei 1:5 bis 10:1 liegt.